# EUROPÄISCHE PATENTSCHRIFT

(11) **EP 3 462 612 B1**
(45) Veröffentlichungstag und Bekanntmachung des Hinweises auf die Patenterteilung: **16.03.2022**
(21) Anmeldenummer: 18200071.1
(22) Anmeldetag: 18.08.2015
(51) Int. Cl.: H03H 7/38

(54) **ANTENNENSCHALTUNG FÜR NAHFELD-ANTENNEN**
ANTENNA CIRCUIT FOR NEAR-FIELD ANTENNAS
CIRCUIT D'ANTENNE POUR ANTENNES DE CHAMP PROCHE

(30) Priorität: 25.09.2014 DE 102014113910
(43) Veröffentlichungstag der Anmeldung: 03.04.2019
(62) Teilanmeldung aus: 15181362.3
(73) Patentinhaber: HUF Hülsbeck & Fürst GmbH & Co. KG, 42551 Velbert (DE)
(72) Erfinder: SIEG, Berthold, 46240 Bottrop (DE)
(74) Vertreter: Bals, Rüdiger

(56) Entgegenhaltungen:
- WO-A1-2014/132823
- DE-A1-102013 015 736
- US-A- 5 969 582
- GEBHART MICHAEL ET AL: "Automated antenna impedance adjustment for Near Field Communication (NFC)", PROCEEDINGS OF THE 12TH INTERNATIONAL CONFERENCE ON TELECOMMUNICATIONS, IEEE, 26. Juni 2013 (2013-06-26), Seiten 235-242, XP032477548, ISBN: 978-1-4673-5984-9 [gefunden am 2013-08-12]
- Philips: "Micore Reader IC Family; Directly Matched Antenna Design - Rev 2.05", Philips Application Notes , 10. Mai 2006 (2006-05-10), Seiten 1-42, XP055248847, Gefunden im Internet: URL:http://www.nxp.com/documents/applicati on_note/AN077925.pdf [gefunden am 2016-02-09]

## Beschreibung

Die Erfindung betrifft eine Antennenschaltung, insbesondere eine Antennenanpassungsschaltung zum Einsatz mit Sendeantennen für eine Nahfeldkommunikation. Die Nahfeldkommunikation (NFC) ist eine im Stand der Technik bekannte und erprobte Kommunikationstechnik, um eine Authentifizierung, ein Datenaustausch oder eine Bezahlvorgang durch Annähern zweier Sende/Empfangseinrichtungen zueinander zu ermöglichen.

Die Nahfeldkommunikation ist eine kontaktfreie Technik, die im Bereich von einigen Megahertz, üblicherweise 13,56 Megahertz unter Verwendung induktiver Schleifenantennen arbeitet.

Es gibt im Stand der Technik zahlreiche Ansätze, die Ansteuerung derartiger Schleifenantennen in einerseits kostenoptimierter Weise und andererseits qualitativ optimierter Weise durchzuführen.

Die Druckschrift DE 10 2013 015 736 A1 offenbart beispielsweise eine Antennenanpassungsschaltung mit einer symmetrischen Filterschaltung. Außerdem sind verschiedene Normenwerke bekannt, die konkrete Anforderungen an Nahfeld-NFC-Kommunikationssysteme enthalten. Beispiele für diese Referenzen und Normenwerke sind:
- NFC-Forum (http://www.nfc.org)
- ISO 14443 1-4 (short distance: MiFare, DESFire ...)
- ISO 10373-6 (Identification cards - Test Methods -)
- JIS 6319 (FeliCa SONY),
- ISO 15693 (vicinity cards - greater distance - Logistic)

Ein weiteres Beispiel aus dem Stand der Technik, welches sich mit der Impedanzanpassung für NFC-Systeme befasst ist der Artikel "Automated Antenna Impedence Adjustment for Near Field Communication (NFC)" von Michael Gebhart, Thomas Baier, Marc Faccini, Telecommunications (Contel), 2013, 12th International Conference (ISBN 978-1-4673-5984-9).

Das grundlegende Prinzip der Ausbildung einer Antennenschaltung ist außerdem bei den Herstellern von Betreiberschaltungen im Zusammenhang mit ihren Produkten publiziert. Lediglich beispielhaft wird dazu auf die Dokumentation der Philips Semiconductors zur "Micore Reader IC Family " in der Fassung 2.05 vom 10. Mai 2006 verwiesen. Diese

Publikation erklärt, wie mit Hilfe einer im Markt verfügbaren Treiberschaltung und einer anwendungsspezifisch designten Antenne eine zugehörigen Filterschaltung für eine EMV-Filterung und einer Impedanzanpassungsschaltung zur Schaltung zwischen Treiberschaltung und Antenne zu designen ist.

Weitere Anpassungsschaltungen sind der WO 2014/132823 A1, der US 2016/013770 A1 und der DE 10 2013 015736 A1 zu entnehmen.

Die Funktionalität einer resultierenden Antennenschaltung besteht zunächst in der Übertragung von Leistung, wobei das abgestrahlte magnetische Feld unter Beachtung den Bauartbedingten Limitierungen zu maximieren ist sowie unter Berücksichtigung der Abstrahlung von Harmonischen der Sendefrequenz.

Weiterhin hat das amplitudenmodulierte Signal hinsichtlich Signalformung und Timing des Signals so übertragen zu werden, dass auf Empfangsseite jeder Empfänger das Signal verarbeiten kann. Im Falle des Empfangs von Daten mit der Antennenschaltung hat das empfangende Signal entsprechend der Vorgaben der Treiberschaltung aufbereitet und eingespeist zu werden.

Die schematische Herangehensweise für das Design einer Antennenschaltung wird in diesem genannten Stand der Technik zu beschrieben, wobei zunächst die Antennenspule designt wird und die Induktivität, der Widerstand und die Güte der Spule ermittelt werden. Anschließend werden Resonanzkapazitäten berechnet, um einen Schwingkreis mit der Spule herzustellen. Danach wird dieser Schwingkreis an die erforderliche Impedanz angepasst und mit dem EMV-Tiefpassfilterausgang gekoppelt. Schließlich werden der Gütefaktor und die Empfangsschaltung geprüft und angepasst (fine tuning).

Beachtenswert ist, dass im Stand der Technik vorgeschlagen wird, die Resonanzfrequenz des EMC-Filters zur Verbesserung des Systems oberhalb der Trägerfrequenz anzusetzen, beispielsweise auf etwa 14,4 Megahertz. Dies verbessert gemäß dem Stand der Technik die Empfangsperformance und außerdem auch die Signalqualität des Übertragungssignals. Auf ein solches bekanntes Design einer Antennenschaltung wird angesichts der Tatsache, dass eine ausführliche Beschreibung an zahlreichen Stellen des Standes der Technik vorliegt (wie in der genannten Dokumentation), nicht weiter eingegangen.

Gemäß dem Stand der Technik angepasste und ausgelegte Systeme bringen jedoch im Bereich der Trägerfrequenz dahingehend Probleme mit sich, dass der Eingangsstrom regelmäßig größer ist als der Antennenstrom, jedenfalls aber in der gleichen Größenordnung wie der Antennenstrom. Außerdem weist der Frequenzgang um die Trägerfrequenz starke Schwankungen und Asymmetrien auf, so dass eine bauteiltoleranz-bedingte leichte Frequenzabweichung zu unvorhergesehenen Ergebnissen führen kann.

Aufgabe der Erfindung ist es, eine verbesserte Antennenschaltung für Antennen zur Nahfeldkommunikation bereitzustellen.

Diese Aufgabe wird erfindungsgemäß gelöst durch eine Antennenschaltung mit den Merkmalen des Patentanspruches 1.

Bei der erfindungsgemäßen Antennenschaltung ist der Antennenstrom über einen weiten Frequenzbereich um die Arbeitsfrequenz stabil und der Eingangsstrom über einen weiten Frequenzbereich stark gegenüber dem Stand der Technik erniedrigt.

Die Erfindung bedient sich unter anderem der Prinzipien einer Kopplung von Schwingkreisen miteinander, so wie sie im Bereich der Hochfrequenztechnik untersucht wurde. Es gibt grundsätzlich verschiedene Kopplungsarten, um Schwingkreise induktiv, kapazitiv oder galvanisch miteinander zu koppeln. Aus der Hochfrequenztechnik sind die Begriffe der sogenannten unterkritischen Kopplung, der kritischen Kopplung und der überkritischen Kopplung von Schwingkreisen bekannt.

Die erfindungsgemäße Lösung sieht nun vor, eine kritische Kopplung zwischen dem Antennenkreis der vorgeschalteten Antennenschaltung herzustellen, so dass ein flacher Mittelteil im Frequenzgang des Antennenstromes erreicht wird. Die herkömmliche Bauart führt zu einer überkritischen Kopplung, bei der die Übertragungsfunktion in der Mitte mehr oder weniger stark einen Sattel ausbildet und zu der unerwünschten starken Frequenzabhängigkeit führt.

Erfindungsgemäß wird also eine kritische Kopplung hergestellt, wobei in der erfindungsgemäßen Anpassung der Schaltung die Filterschaltung zusammen mit der Anpassungsschaltung in die Kopplungsbetrachtung mit der Antenne aufgenommen wird. Während die herkömmliche Herstellung einer Antennenschaltung von der Antenne ausgehend zunächst die Impedanzanpassung vornahm und danach die impedanzangepasste Schaltung mit dem EMV-Filter koppelte und schließlich eine Optimierung vornahm, geht die erfindungsgemäße Gestaltung den Weg, die Anforderung der kritischen Kopplung auf die Anpassungsschaltung und den Filter gemeinsam auszudehnen.

Es hat sich dabei insbesondere bewährt, die wirksamen Gesamtkapazitäten und Gesamtinduktivitäten einerseits im Antennenkreis und andererseits im kombinierten Filter und Anpassungskreis im Wesentlichen gleich zu wählen, wobei gleich in diesem Falle zunächst dieselbe Größenordnung bedeutet und insbesondere Abweichungen bis 20% der Wertezulässt, um Feinabstimmungen vorzunehmen.

Bei dieser gemeinsamen Betrachtung des Filters und der Anpassungsschaltung wird es möglich, die Position der Impedanzanpassung zur Optimierung der Wirkströme zumindest teilweise oder auch vollständig in das Filternetzwerk zu verlagern.

Diese Gesamtbetrachtung des Antennennetzwerkes, also die Betrachtung der Gesamtheit aus Filterschaltung und Anpassungsschaltung einerseits und der Antennenspule andererseits ermöglicht die erfindungsgemäße kritische Kopplung, bei der ein Eingangsstrom im Bereich der Trägerfrequenz deutlich niedriger ist als der Antennenstrom.

Im Rahmen der Erfindung führt eine derartige erfindungsgemäße Anpassung dazu, dass die Werte der Kopplung, also die Kapazitätswerte der Kopplungskapazität bei einer kapazitiven Kopplung, deutlich höher liegen als bei herkömmlichen Antennenschaltungen. Höhere Kopplungswerte sind toleranzunabhängiger und liefern entsprechend verlässlichere Übertragungen. Die Fertigung wird hinsichtlich der Fehlertoleranz und Fertigungskosten verbessert.

Die Erfindung wird nun anhand der beiliegenden Zeichnungen näher erläutert.
- Figur 1a: zeigt eine beispielhafte Antennenschaltung gemäß dem Stand der Technik;
- Figur 1b: zeigt einen Frequenzgang, wie er durch Simulation der Antennenschaltung aus Fig. 1a berechnet wurde;
- Figur 2a: zeigt eine Antennenschaltung gemäß einer ersten Ausführungsform der Erfindung;
- Figur 2b: zeigt einen Frequenzgang, wie er durch Simulation der Antennenschaltung aus Fig. 2a berechnet wurde.

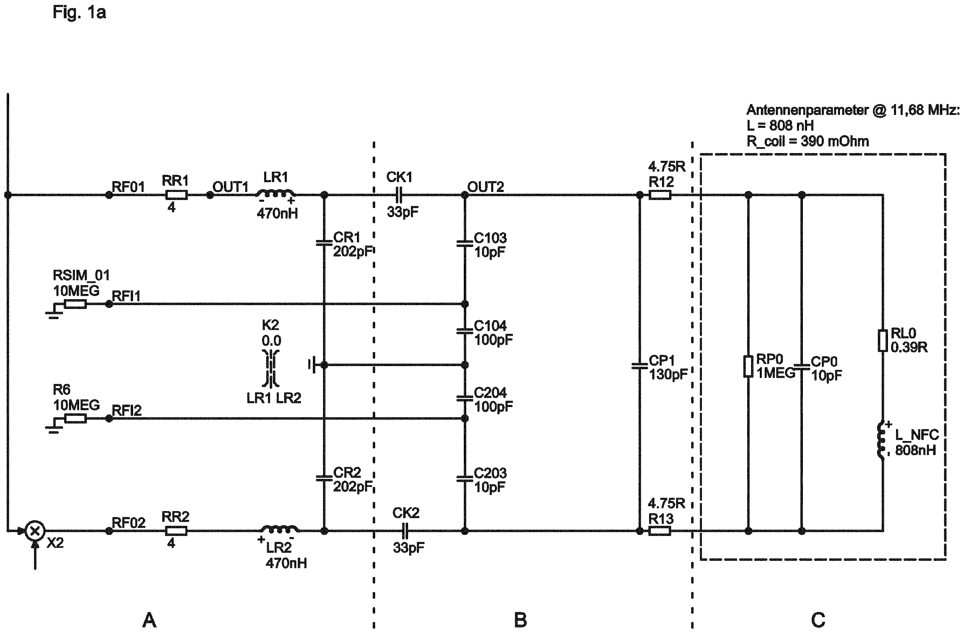

In Figur 1a ist das Schaltbild aus einer Schaltungssimulation zur Ansteuerung einer NFC-Antenne gemäß dem Stand der Technik dargestellt. Der Abschnitt A stellt das Netzwerk zur EMV-Filterung dar, Abschnitt B bezeichnet die Impedanz-Anpassungsschaltung und Abschnitt C ist ein Ersatzschaltbild für die Antennenanordnung. Die Antennenparameter bei einer Frequenz von 11,68 MHz betragen in diesem Beispiel 808 nH und haben einen Spulenwiderstand von 390 mOhm. Die dargestellte Schaltung ist gemäß der Vorgaben von Herstellern von Treiberschaltungen optimiert und betrachtet ausgehend von der Antenne (C) und deren gemessenen Eigenschaften zunächst die Impedanzanpassung (B) und anschließend die Filterung (A) sowie eine abschließende Optimierung.

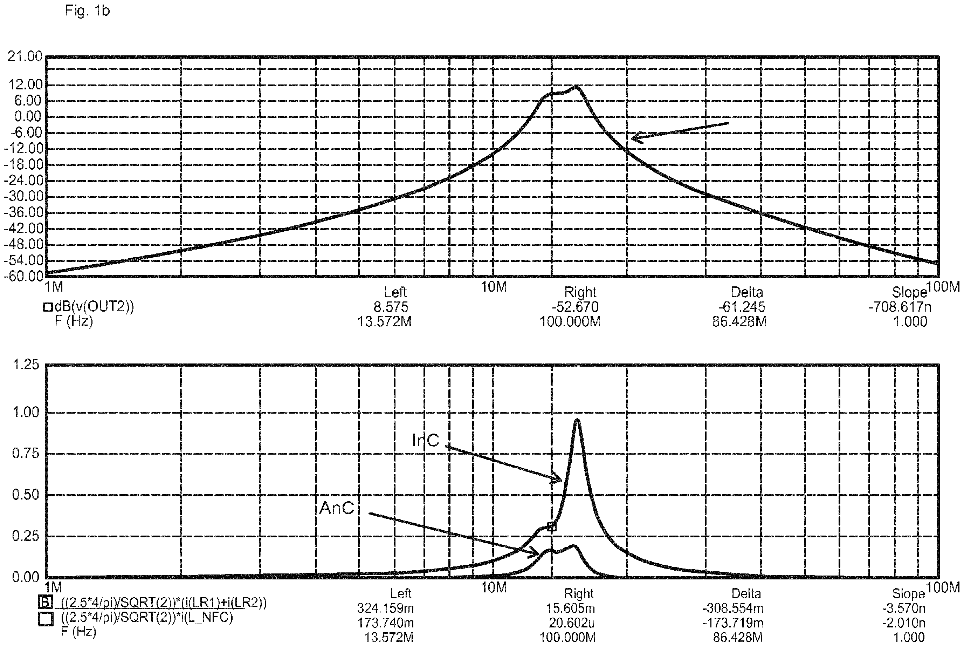

In Figur 1b ist in der oberen Hälfte die Filterkurve der Schaltung aus Figur 1a gezeigt. Der Frequenzgang des Antennenstromes (AnC) sowie des Eingangsstromes (InC) ist in der unteren Hälfte der Figur 1b gezeigt.

Es ist ersichtlich, dass der Eingangsstrom in diesem Beispiel oberhalb des Antennenstromes liegt, insbesondere bei der Trägerfrequenz 13,572 Megahertz. Der Antennenstrom weist außerdem eine deutliche Frequenzabhängigkeit im Bereich um die erwünschte Trägerfrequenz auf.

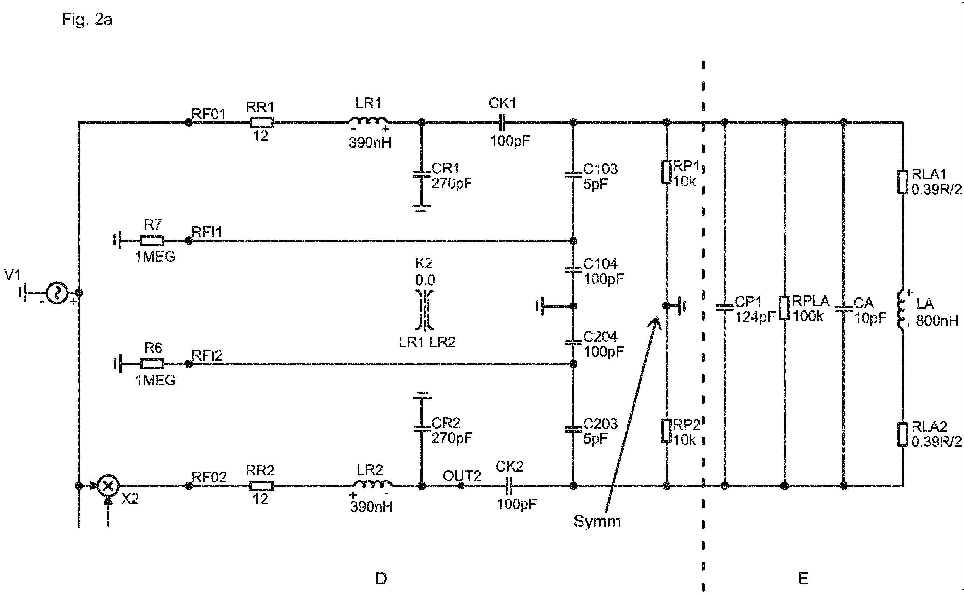

Figur 2a zeigt eine erfindungsgemäße Ausführungsform eines Filters. Die Induktivitäten als auch die Kapazitäten und Widerstände im Filternetzwerk als auch im Anpassungsnetzwerk wurden betrachtet, um eine kritische Kopplung der Schwingkreise mit der Antennenspule herzustellen.

Im diesem Beispiel wurden die Kapazitäten und Induktivitäten in der Kombination aus Filternetzwerk und Anpassungsnetzwerk (Netzwerk D) so gewählt, dass die Gesamtinduktivitäten und Kapazitäten in diesen Netzwerken mit den gesamten Kapazitäten und Induktivitäten im Antennennetzwerk (Netzwerk E) weitgehend übereinstimmen. Die Abweichung beträgt in diesem Beispiel weniger als 20%. Die Impedanzanpassung durch ohmsche Widerstände wurde außerdem aus dem Kopplungsstrang zwischen Antenne und Anpassungsnetzwerk in das Filternetzwerk (Widerstände RR1, RR2) verlegt, um optimierte Wirkströme zu erhalten. Die Kopplungskapazitäten CK1, CK2 wurden gegenüber dem Stand der Technik deutlich vergrößert, wobei höhere Kopplungswerte auch toleranzunabhängiger hinsichtlich der Bauteiltoleranzen sind.

Der Ausgangskreis wurde außerdem in diesem Beispiel symmetrisch (siehe Massepunkt Symm) ausgeführt, während er im Beispiel gemäß dem Stand der Technik nicht symmetriert war.

Es ist ersichtlich, dass die Summe der Induktivitäten LA1 und LA2 etwa die Induktivität der gekoppelten Antennenspule LA ergibt. Eine kritische Kopplung nach den Maßgaben der Hochfrequenztechnik ist nun zwischen dem gesamten Netzwerk D und der Spule E hergestellt.

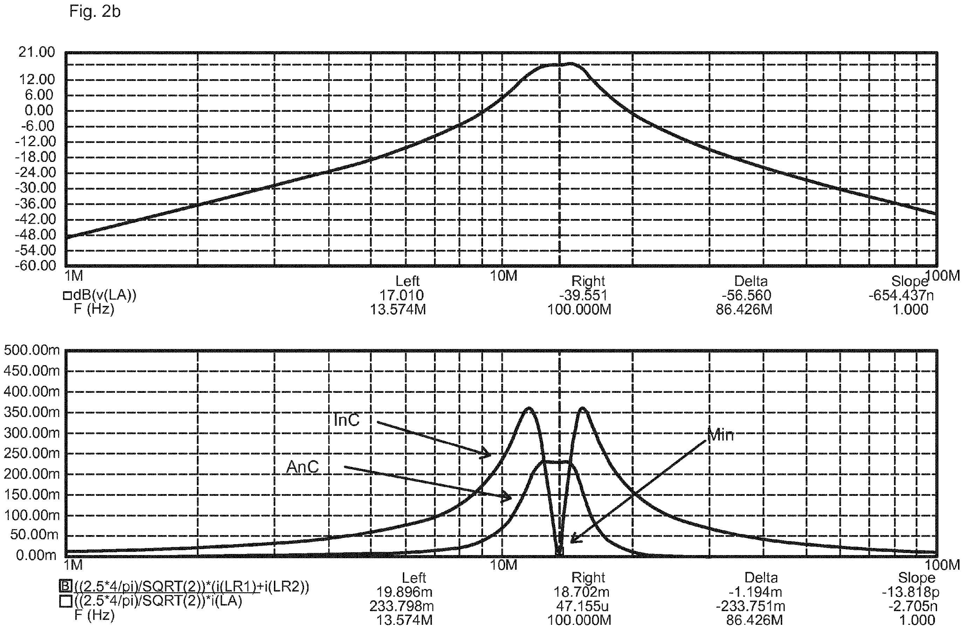

Das Ergebnis dieser erfindungsgemäßen Betrachtung die eine Kopplung der Schwingkreise unter Einbeziehung der Gesamtheit aus Filternetzwerk und der Anpassung einbezieht, ist in Figur 2b zu sehen. Auch dort ist im oberen Abschnitt die Filterkurve dargestellt und im unteren Abschnitt ist der Frequenzgang des Eingangsstromes und des Antennenstromes dargestellt. Der Antennenstrom (AnC) weist nun ein breites Plateau um die Zielfrequenz 13,574 MHz auf und für den Eingangsstrom (InC) ist eine ausgeprägte Strom-Minimumskerbe (Min) bei der Arbeitsfrequenz erkennbar. Dieses Verhalten der Schaltung führt zu einer deutlichen Verbesserung der Performance der gesamten Antennenschaltung.

## Patentansprüche

1. Kommunikationseinrichtung für ein Kraftfahrzeug, mit einer Nahfeld-Kommunikationseinrichtung, welche einen Antennenabschnitt, eine Treiberschaltung und eine zwischen der Treiberschaltung und dem Antennenabschnitt angeordnete Anpassungsschaltung und Filterschaltung aufweist, wobei der Antennenabschnitt einen elektrischen ersten Schwingkreis mit einer ersten Resonanzfrequenz bildet, wobei die Anpassungsschaltung und die Filterschaltung wenigstens einen zweiten Schwingkreis mit einer zweiten Resonanzfrequenz bilden, **dadurch gekennzeichnet, dass** der erste Schwingkreis mit dem zweiten Schwingkreis gemäß einer kritischen Kopplung gekoppelt ist.

2. Kommunikationseinrichtung nach Anspruch 1, wobei der zweite Schwingkreis ein Serienschwingkreis ist.

3. Kommunikationseinrichtung nach Anspruch 1 oder 2, wobei die wirksame Gesamtkapazität der Anpassungsschaltung und Filterschaltung der wirksamen Gesamtkapazität des Antennenabschnitts entspricht, insbesondere um weniger als 25%, bevorzugt um weniger als 15% davon abweicht.

4. Kommunikationseinrichtung nach einem der vorangehenden Ansprüche, wobei die wirksame Gesamtinduktivität der Anpassungsschaltung und Filterschaltung der wirksamen Gesamtinduktivität des Antennenabschnitts entspricht, insbesondere um weniger als 25%, bevorzugt um weniger als 15% davon abweicht.

5. Kommunikationseinrichtung nach einem der vorangehenden Ansprüche, wobei die Filterschaltung wenigstens teilweise als symmetrische Filterschaltung ausgebildet ist.

6. Kommunikationseinrichtung nach einem der vorangehenden Ansprüche, wobei die Anpassungsschaltung wenigstens teilweise als symmetrische Anpassungsschaltung ausgebildet ist.

7. Kommunikationseinrichtung nach einem der vorangehenden Ansprüche, wobei der Antennenabschnitt als symmetrischer Ausgangskreis mit zentraler Masseanbindung ausgebildet ist.

## Claims

1. A communication device for a motor vehicle, comprising a near-field communication device having an antenna section, a driver circuit, and a matching circuit and filter circuit disposed between the driver circuit and the antenna section, wherein the antenna section forms an electrical first resonant circuit having a first resonant frequency,
wherein the matching circuit and the filter circuit form at least a second resonant circuit having a second resonant frequency,
**characterized in that**
the first resonant circuit is coupled to the second resonant circuit in accordance with a critical coupling.

2. The communication device according to claim 1,
wherein the second resonant circuit is a series resonant circuit.

3. The communication device according to claim 1 or 2,
wherein the total effective capacitance of the matching circuit and filter circuit corresponds to the total effective capacitance of the antenna section, in particular deviates therefrom by less than 25%, preferably by less than 15%.

4. The communication device according to any one of the preceding claims,
wherein the effective total inductance of the matching circuit and filter circuit corresponds to the effective total inductance of the antenna section, in particular deviates therefrom by less than 25%, preferably by less than 15%.

5. The communication device according to any one of the preceding claims,
wherein the filter circuit is formed at least partially as a symmetrical filter circuit.

6. The communication device according to any one of the preceding claims,
wherein the matching circuit is at least partially formed as a balanced matching circuit.

7. The communication device according to any one of the preceding claims,
wherein the antenna section is designed as a symmetrical output circuit with a central ground connection.

## Revendications

1. Dispositif de communication pour un véhicule automobile, comprenant un dispositif de communication en champ proche qui comporte une section d'antenne, un circuit d'attaque, et un circuit d'adaptation et un circuit de filtrage disposés entre le circuit d'attaque et la section d'antenne, dans lequel la section d'antenne forme un premier circuit électrique résonant ayant une première fréquence de résonance,
dans lequel le circuit d'adaptation et le circuit de filtrage forment au moins un second circuit résonant ayant une seconde fréquence de résonance,
**caractérisé en ce que**
le premier circuit résonant est couplé au deuxième circuit résonant selon un couplage critique.

2. Dispositif de communication selon la revendication 1,
le deuxième circuit résonant étant un circuit résonant série.

3. Dispositif de communication selon la revendication 1 ou 2,
dans lequel la capacité totale efficace du circuit d'adaptation et du circuit de filtrage correspond à la capacité totale efficace de la section d'antenne, en particulier s'en écarte de moins de 25%, de préférence de moins de 15%.

4. Dispositif de communication selon l'une des revendications précédentes,
dans lequel l'inductance totale efficace du circuit d'adaptation et du circuit de filtrage correspond à l'inductance totale efficace de la section d'antenne, en particulier s'en écarte de moins de 25%, de préférence de moins de 15%.

5. Dispositif de communication selon l'une des revendications précédentes,
le circuit de filtrage étant conçu au moins partiellement comme un circuit de filtrage symétrique.

6. Dispositif de communication selon l'une des revendications précédentes,
le circuit d'adaptation étant conçu au moins partiellement comme un circuit d'adaptation symétrique.

7. Dispositif de communication selon l'une des revendications précédentes,
la section d'antenne étant conçue comme un circuit de sortie symétrique avec une connexion de masse centrale.
